(19) Europäisches Patentamt
European Patent Office
Office européen des brevets

(11) **EP 3 564 998 A1**

(12) **EUROPEAN PATENT APPLICATION**
published in accordance with Art. 153(4) EPC

(43) Date of publication:
06.11.2019 Bulletin 2019/45

(51) Int Cl.:
*H01L 27/12* (2006.01)          *H01L 21/77* (2017.01)
*H01L 51/52* (2006.01)          *G02F 1/13* (2006.01)

(21) Application number: 17885656.3

(22) Date of filing: 18.12.2017

(86) International application number:
**PCT/CN2017/116916**

(87) International publication number:
**WO 2018/121322 (05.07.2018 Gazette 2018/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD TN**

(30) Priority: 27.12.2016  CN 201611229509
31.08.2017  CN 201710774762

(71) Applicants:
• **Kunshan New Flat Panel Display
Technology Center Co., Ltd.
Kunshan, Jiangsu 215300 (CN)**
• **Kunshan Go-Visionox Opto-Electronics Co., Ltd.
KunShan City, Jiangsu 215300 (CN)**

(72) Inventors:
• **HU, Kun
Kunshan, Jiangsu 215300 (CN)**

• **FENG, Hao
Kunshan, Jiangsu 215300 (CN)**
• **YUAN, Bo
Kunshan, Jiangsu 215300 (CN)**
• **CAI, Shixing
Kunshan, Jiangsu 215300 (CN)**
• **ZHANG, Tingting
Kunshan, Jiangsu 215300 (CN)**
• **SONG, Yanqin
Kunshan, Jiangsu 215300 (CN)**
• **LIN, Li
Kunshan, Jiangsu 215300 (CN)**
• **HU, Siming
Kunshan, Jiangsu 215300 (CN)**
• **ZHU, Hui
Kunshan, Jiangsu 215300 (CN)**

(74) Representative: **Kraus & Weisert
Patentanwälte PartGmbB
Thomas-Wimmer-Ring 15
80539 München (DE)**

(54) **FLEXIBLE DISPLAY DEVICE AND MANUFACTURING METHOD THEREFOR**

(57) A flexible display device and a manufacturing method therefor. The flexible display device comprises a flexible substrate(10) and an electrically conductive layer (110) formed on the flexible substrate. At least one recessed region (111) is arranged on the electrically conductive layer. Because of existence of the recessed region, the electrically conductive layer is free of cracks or is prevented from being broken in the process in which the flexible display device is bent or folded, thereby improving the quality and reliability of the electrically conductive layer when the electrically conductive layer is bent.

FIG. 1

**Description**

TECHNICAL FIELD

The disclosure relates to the field of display technology, and in particular to a flexible display device and a manufacturing method therefor.

BACKGROUND

A flexible display device refers to a display device in which a display panel is bendable and deformable, which includes various types such as a flexible Organic Light Emitting Diode (OLED) device, a flexible Electrophoresis Display (EPD) device, and a flexible Liquid Crystal Display (LCD) device and so on. As a new generation of the display device, the flexible display device has the advantages such as being thin and light, also it has high contrast, fast response, wide viewing angle, high brightness, full color and so on. Therefore, the flexible display device has a wide range of application prospects in mobile phones, Personal Digital Assistants (PDAs), digital cameras, car displays, notebook computers, wall-mounted TVs and the military field.

A brittle TFT (Thin Film Transistor) is extremely prone to breakage during a bending or a folding process of the flexible display device, the broken TFT may affect the display effect of the flexible display device or directly cause malfunction of the flexible display device. It was found that, the breakage of the brittle TFT is mainly concentrated on the thicker conductive layer around the periphery of the screen, especially in a flexible and foldable direction of the conductive layer.

In the prior art, for the easily broken conductive layer, there are a plurality of solutions to enhance mechanical reliability of the conductive layer, such as punching on the conductive layer to release stress; providing multiple conductive layers and connecting the multiple conductive layers by using contact holes; replacing electrode material with graphene, Nano-silver wire and so on; reducing the width of the conductive layer and improving the smoothness of the conductive layer. However, the technical effect of the above-mentioned solutions to enhance the mechanical reliability of the conductive layer in the prior art is not satisfactory.

SUMMARY

In view of this, the disclosure provides a flexible display device and a manufacturing method therefor, to solve the problem that in the prior art, a conductive layer of the flexible display device is prone to crack or even break in the process of bending or folding the flexible display device.

In a first aspect, an embodiment of the disclosure provides a flexible display device. The flexible display device includes a flexible substrate and a conductive layer disposed on the flexible substrate, and having at least a recessed region disposed thereon.

In an embodiment of the disclosure, the conductive layer forms a power line on the flexible substrate.

In an embodiment of the disclosure, a longest one of all sides of the recessed region or a longest one of all side connecting lines that connect two points of the sides of the recessed region is consistent with a bending direction of the flexible display device.

In an embodiment of the disclosure, the recessed region includes a through hole and/or a blind hole.

In an embodiment of the disclosure, the conductive layer and the flexible substrate are divided into a bending zone and a non-bending zone along an extension direction, and the at least a recessed region is disposed on the bending zone of the conductive layer, a thickness of the conductive layer in the bending zone is greater than a thickness of the conductive layer in the non-bending zone.

In an embodiment of the disclosure, an upper edge or a lower edge of a non-extension direction of the bending zone of the conductive layer is collinear with the same side edge of the non-bending zone of the conductive layer.

In an embodiment of the disclosure, an upper edge or a lower edge of a non-extension direction of the bending zone of the conductive layer is not collinear with the same side edge of the non-bending zone of the conductive layer.

In an embodiment of the disclosure, the flexible display device utilizes a thin film transistor structure, the conductive layer is electrically connected with a source electrode, a drain electrode, a gate electrode, a cathode or an anode of the flexible display device; or the source electrode, the drain electrode, the gate electrode, the cathode or the anode of the flexible display device is constituted by the conductive layer.

In an embodiment of the disclosure, the flexible display device utilizes the thin film transistor structure, and a top gate and/or a bottom gate in the gate electrode of the flexible display device is constituted by the conductive layer, the gate electrode includes the top gate disposed above a channel layer of the thin film transistor and the bottom gate disposed under the channel layer; the recessed region is disposed on the top gate, and a projection of the recessed region of the top gate on a plane parallel to the channel layer is covered by a projection of the bottom gate on the plane;

and/or, the recessed region is disposed on the bottom gate, and a projection of the recessed region of the bottom gate on a plane is covered by a projection of the top gate on the plane.

In an embodiment of the disclosure, a shape of the projection of the recessed region of the top gate on the plane is the same as a shape of the projection of the bottom gate on the plane; and/or, the shape of the projection of the recessed region of the bottom gate on the plane is the same as the shape of the projection of the top gate on the plane.

In an embodiment of the disclosure, the at least a recessed region of the conductive layer is filled with an organic material.

In an embodiment of the disclosure, the at least a recessed region is arranged in one or more rows along a bending direction of the flexible display device.

In an embodiment of the disclosure, the recessed regions arranged in a plurality of rows are aligned or staggered.

In an embodiment of the disclosure, a ratio of a cross-sectional width of one recessed region in a width direction of the power line or the sum of cross-sectional widths of a plurality of recessed regions in a same column in the width direction of the power line to a width of the conductive layer is smaller than or equal to 1/2.

In an embodiment of the disclosure, a ratio of a minimum spacing between two adjacent recessed regions in a same row to a length of a side or a side connecting line consistent with a bending direction of the flexible display device is greater than or equal to 1/2 and smaller than or equal to 2.

In an embodiment of the disclosure, a projection of the recessed region on a plane parallel to the flexible substrate includes one or multiple combinations of following shapes: a rectangle shape, a triangle shape, a trapezoidal shape, a rhombus shape, a circular shape, an ellipse shape, a sinusoidal shape, a twisted shape and a zigzag shape.

In an embodiment of the disclosure, the flexible display device includes a protective layer disposed on the conductive layer, and a ratio of an aperture of the recessed region of the conductive layer covered by the protective layer to a width of the conductive layer is smaller than 0.1.

In an embodiment of the disclosure, the flexible display device includes a protective layer disposed on the conductive layer, and a ratio of an aperture of the recessed region of the conductive layer covered without the protective layer to a width of the conductive layer is greater than 0.08.

In a second aspect, an embodiment of the disclosure also provides a method of manufacturing a flexible display device. The method of manufacturing the flexible display device includes: forming a flexible substrate; determining resistance requirement of a power line; obtaining information about a width of a conductive layer and a recessed region according to the resistance requirement of the power line; and forming the power line on the flexible substrate according to the information about the width of the conductive layer and the recessed region.

In a third aspect, an embodiment of the disclosure also provides a method of manufacturing a flexible display device, the flexible display device is a thin film transistor structure, and a method of manufacturing the gate electrode of the thin film transistor structure includes: making a bottom gate; sequentially making a bottom gate insulated layer and a channel layer above the bottom gate; and sequentially making a top gate insulated layer and a top gate above the channel layer; at least one recessed region is disposed on the top gate, the projection of the at least one recessed region on the top gate on the plane parallel to the channel layer is covered by the projection of the bottom gate on the plane parallel to the channel layer; and/or at least one recessed region is disposed on the bottom gate, the projection of the at least one recessed region on the bottom gate on the plane parallel to the channel layer is covered by the projection of the top gate on the plane parallel to the channel layer.

The flexible display devices provided by the embodiments of the disclosure include the flexible substrate and the conductive layer disposed on the flexible substrate, and the at least one recessed region is disposed on the conductive layer. The flexible display devices provided by the embodiments of the disclosure prevent the conductive layer from being cracked or broken and improve the quality and reliability of the conductive layer during the bending or folding process of the flexible display device by means of disposing the conductive layer on the flexible substrate and disposing the at least one recessed region on the conductive layer.

BRIEF DESCRIPTION OF DRAWINGS

FIG. 1 is a structural schematic diagram of a flexible display device in accordance with a first embodiment of the disclosure.

FIG. 2 is a structural schematic diagram of a flexible display device in accordance with a second embodiment of the disclosure.

FIG. 3 is a structural schematic diagram of a flexible display device in accordance with a third embodiment of the disclosure.

FIG. 4 is a structural schematic diagram of a flexible display device in accordance with a fourth embodiment of the disclosure.

FIG. 5 is a structural schematic diagram of a flexible display device in accordance with a fifth embodiment of the disclosure.

FIG. 6 is a structural schematic diagram of a flexible display device in accordance with a sixth embodiment of the disclosure.

FIG. 7a is a structural schematic diagram of a thin film transistor structure of a flexible display device in accordance with a seventh embodiment of the disclosure.

FIG. 7b is a projection schematic diagram of a gate electrode of the thin film transistor structure of the flexible display device in accordance with the seventh embodiment of the disclosure.

FIG. 8a is a structural schematic diagram of a thin film transistor structure of a flexible display device in accordance with an eighth embodiment of the disclosure.

FIG. 8b is a projection schematic diagram of a gate electrode of the thin film transistor structure of the flexible display device in accordance with the eighth embodiment of the disclosure.

FIG. 9 is a schematic flowchart showing a production process of a gate electrode of a thin film transistor structure of a flexible display device in accordance with a ninth embodiment of the disclosure.

FIG. 10 is a polyline schematic diagram of bending performance experimental information of a flexible display device in accordance with a tenth embodiment of the disclosure.

FIG. 11 is a polyline schematic diagram of bending performance experimental information of a flexible display device in accordance with an eleventh embodiment of the disclosure.

## DESCRIPTION OF EMBODIMENTS

In order to make the purposes, technical means and advantages of the disclosure clearer, the disclosure will be further described in detail below with reference to the accompanying drawings. The advantages and characteristics of the disclosure will be more apparent from the following description and claims. It can be noted that, the accompanying drawings are all in a very simplified form and all use an inaccurate scale for the purpose of facilitating and clearly illustrating the embodiments of the disclosure.

First Embodiment

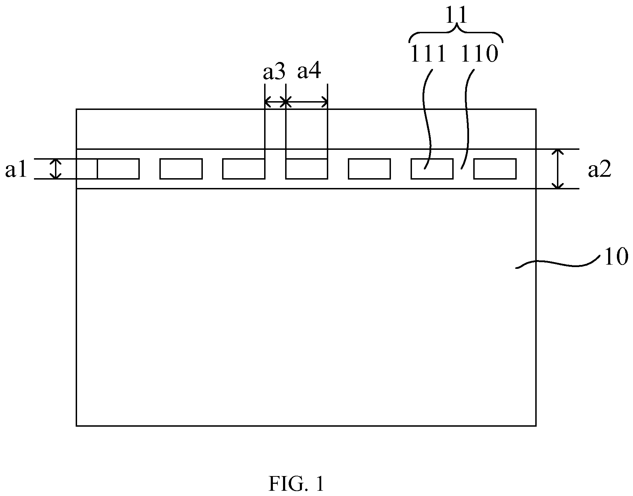

FIG. 1 is a structural schematic diagram of a flexible display device in accordance with a first embodiment of the disclosure. As shown in FIG. 1, the flexible display device includes a flexible substrate 10 and a power line 11 disposed thereon, the power line 11 includes a conductive layer 110 having through holes 111 disposed therein. By using the through holes 111, the stress produced by bending the power line 11 may be dispersed, thereby preventing the power line from being cracked or broken in the process of bending or folding the flexible display device, and improving the quality and reliability of the power line during it is bent.

In this embodiment of the disclosure, the material of the conductive layer 110 may be a metal material such as aluminum or copper, and the conductive layer 110 may also be a composite metal layer composed of a plurality of metal materials, and further the conductive layer 110 may also be a conductive layer composed of transparent materials such as indium tin oxide. Other materials may be used for the conductive layer 110 as long as they are electrically conductive.

Preferably, a longest one of all sides of any through hole 111 or a longest one of all side connecting lines that connect two points of the sides of the through hole 111 is consistent with a bending direction of the power line 11. It may be understood that the side refers to any side of the through hole, and the side connecting line refers to the line connecting any two points on any side of the through hole. Here, the bending direction refers to an axial direction in which the power line 11 is bent, i.e., a direction in which the stress is transmitted when the power line 11 is bent. Further, the bending direction of the power line 11 is perpendicular to the bending line produced by bending the power line 11. For example, if the shape of the flexible display device is rectangular, and the bending operation is performed along a long side of the flexible display device, that is, the two short sides of the flexible display device are gradually approached or overlapped, at this time the bending direction is the axial direction where the long side is located.

Continuing to refer to FIG. 1, in this embodiment of the present application, the shape of the through holes 111 is rectangular. Further, the long sides of the rectangular through holes (i.e. the longest sides) are consistent with the bending direction of the power line 11, that is, the long sides of the rectangular through holes are consistent with the bending direction of the flexible display device. Thereby, the stress produced by bending the power line 11 may be better dispersed by the through holes 111.

Preferably, a row of through holes 111 is disposed on the conductive layer 110 every 200 $\mu$m-500 $\mu$m in the width direction, and one or more rows of through holes 111 are evenly arranged on the conductive layer 110, thereby, a certain number of through holes can be ensured, so that the stress generated by bending the power line 11 is better dispersed, and the quality and reliability of the conductive layer 110 can also be ensured. For example, when the width of the conductive layer 110 is smaller than 500 $\mu$m, the conductive layer 110 has one row of through holes 111; when the width of the conductive layer 110 is greater than or equal to 500 $\mu$m and smaller than 1000 $\mu$m, the conductive layer 110 has two rows of through holes 111; when the width of the conductive layer 110 is greater than or equal to 1000 $\mu$m and smaller than 1500 $\mu$m, the conductive layer 110 has three rows of through holes 111; when the width of the conductive layer 110 is greater than or equal to 1500 $\mu$m and smaller than 2000 $\mu$m, the conductive layer 110 has four rows of through holes 111. Further, when the conductive layer 110 has a greater width (greater than 2000 $\mu$m), more rows of through holes 111 may be arranged on the conductive layer 110. By selecting and matching the width of the conductive layer 110 and the number of rows of through holes 111 reasonably, the bending resistance of the power line 11 can be improved, and the power line 11 can be made to have better electrical conductivity. In this embodiment, the number of through holes 111 is seven, and the seven through holes 111 are arranged in one row.

Preferably, a ratio of a cross-sectional width of one through hole 111 in the width direction in a same column or the sum of cross-sectional widths of a plurality of through holes 111 in the same column in the width direction to the width of the conductive layer 110 is smaller than or equal to 1/2. In this embodiment, a ratio of a short side a1 of the rectangular through hole 111 to the width a2 of the conductive layer 110 is smaller than or equal to 1/2. Further, a ratio of the minimum spacing a3 between two adjacent through holes 111 in the same row to the longest side or the longest side connecting line (i.e. the longer side a4 of the rectangular through hole 111) is greater than or equal to 1/2 and smaller than or equal to 2. Thereby, the bending resistance of the power line 11 can be improved, and the power line 11 can be made to have better electrical conductivity.

Accordingly, the present embodiment also provides a manufacturing method of the flexible display device, which includes: forming a flexible substrate; determining resistance requirement of a power line; obtaining information about through holes and a width of a conductive layer according to the resistance requirement of the power line; and forming the power line on the flexible substrate according to the information about the through holes and the width of the conductive layer. Here, forming the power line on the flexible substrate may include: firstly forming the conductive layer with a specific width (i.e., obtaining the width of the conductive layer in accordance with the resistance requirement of the power line); and then punching the conductive layer (i.e., the conductive layer is punched in accordance with the information about the through holes, such as the shape, the size, the number of rows and the number of the through holes, which is obtained by the resistance requirement of the power line).

Second Embodiment

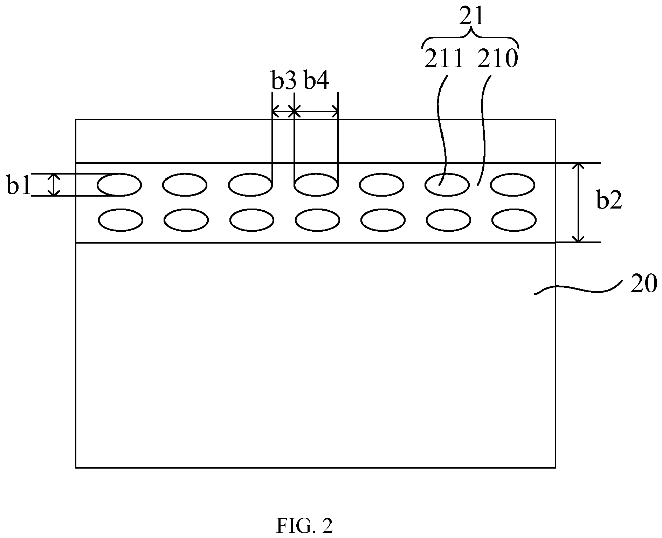

FIG. 2 is a structural schematic diagram of a flexible display device in accordance with a second embodiment of the disclosure. As shown in FIG. 2, the flexible display device includes a flexible substrate 20 and a power line 21 disposed thereon, the power line 21 includes a conductive layer 210 having through holes211 disposed therein. By using the through holes211, the stress produced by bending the power line 21 may be dispersed, thereby preventing the power line from being cracked or broken in the process of bending or folding the flexible display device, and improving the quality and reliability of the power line during it is bent.

In this embodiment of the disclosure, the material of the conductive layer 210 may be a metal material such as aluminum or copper, and the conductive layer 210 may also be a composite metal layer composed of a plurality of metal materials, and further the conductive layer 210 may also be a conductive layer composed of transparent materials such as indium tin oxide. Other materials may be used for the conductive layer 210 as long as they are electrically conductive.

Preferably, a longest one of all sides of any through hole 211 or a longest one of all side connecting lines that connect two points of the sides of the through hole 211 is consistent with a bending direction of the power line 21. Referring to FIG. 2, in this embodiment of the present application, the shape of the through holes 211 is ellipse. Further, the long axes of the ellipse through holes (i.e. the longest side connecting lines) are consistent with the bending direction of the power line 21, that is, the long axes of the ellipse through holes are consistent with the bending direction of the flexible display device. Thereby, the stress produced by bending the power line 21 may be better dispersed by the through holes211.

Preferably, a row of through holes211is disposed on the conductive layer 210 every 200 $\mu$m-500 $\mu$m in the

width direction, and one or more rows of through holes 211 are evenly arranged on the conductive layer 210, thereby, a certain number of through holes can be ensured, so that the stress generated by bending the power line 21 is better dispersed, and the quality and reliability of the conductive layer 210 can also be ensured. In this embodiment of the present application, the number of through holes 211 is fourteen, and the fourteen through holes 211 are arranged in a plurality of rows (for example, arranged in two rows), and the plurality of rows are aligned.

Preferably, a ratio of a cross-sectional width of one through hole 211 in the same column in the width direction or the sum of cross-sectional widths of a plurality of through holes 211 in the same column in the width direction to the width of the conductive layer 210 is smaller than or equal to 1/2. In this embodiment of the present application, the sum of short axes b1 of two ellipse through holes 211 that in the same column (i.e., the sum of the maximum cross-sectional width of a plurality of through holes 211 that in the same column in the width direction) is 2*b1, and a ratio of which to the width b2 of the conductive layer 210 is smaller than or equal to 1/2.Further, a ratio of the minimum spacing b3 between two adjacent through holes 211 in the same row to the longest side or the longest side connecting line (i.e., the long axisb4 of the ellipse through hole 211) is greater than or equal to 1/2 and smaller than or equal to 2. Thereby, the bending resistance of the power line 21 can be improved, and the power line 21 can be made to have better electrical conductivity.

Accordingly, the present embodiment also provides a manufacturing method of the flexible display device, which includes: forming a flexible substrate; determining resistance requirement of a power line; obtaining information about through holes and a width of a conductive layer according to the resistance requirement of the power line; and forming the power line on the flexible substrate according to the information about the through holes and the width of the conductive layer. Here, forming the power line on the flexible substrate may include: firstly forming the conductive layer with a specific width (i.e., obtaining the width of the conductive layer in accordance with the resistance requirement of the power line); and then punching the conductive layer (i.e., the conductive layer is punched in accordance with the information about the through holes, such as the shape, the size, the number of rows and the number of the through holes, which is obtained by the resistance requirement of the power line).

Third Embodiment

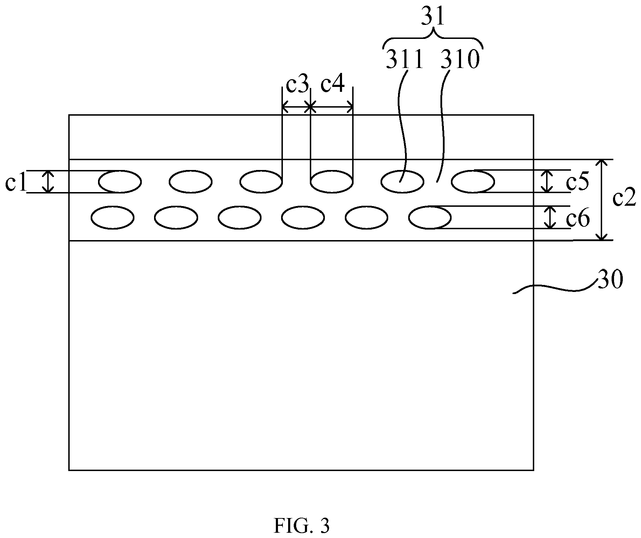

FIG. 3 is a structural schematic diagram of a flexible display device in accordance with a third embodiment of the disclosure. As shown in FIG. 3, the flexible display device includes a flexible substrate 30 and a power line 31 disposed thereon, the power line 31 includes a conductive layer 310 having through holes311 disposed therein. By using the through holes311, the stress produced by bending the power line 31 may be dispersed, thereby preventing the power line from being cracked or broken in the process of bending or folding the flexible display device, and improving the quality and reliability of the power line during it is bent.

In this embodiment, the material of the conductive layer 310 may be a metal material such as aluminum or copper, and the conductive layer 310 may also be a composite metal layer composed of a plurality of metal materials, and further the conductive layer 310 may also be a conductive layer composed of transparent materials such as indium tin oxide. Other materials may be used for the conductive layer 310 as long as they are electrically conductive.

Preferably, a longest one of all sides of any through hole 311 or a longest one of all side connecting lines that connect two points of the sides of the through hole 311 is consistent with a bending direction of the power line 31. Continuing to refer to FIG. 3, in this embodiment of the present application, the shape of the through holes311 is ellipse. Further, the long axes of the ellipse through holes (i.e., the longest side connecting lines) are consistent with the bending direction of the power line 31, that is, the long axes of the ellipse through holes are consistent with the bending direction of the flexible display device. Thereby, the stress produced by bending the power line 31 may be better dispersed by the through holes311.

Preferably, a row of through holes 311 is disposed on the conductive layer 310 every 200 $\mu$m-500 $\mu$m in the width direction, and one or more rows of through holes 311 are evenly arranged on the conductive layer 310, thereby, a certain number of through holes can be ensured, so that the stress generated by bending the power line 31 is better dispersed, and the quality and reliability of the conductive layer 310 can also be ensured. In this embodiment of the present application, the number of through holes 311 is twelve, and the twelve through holes 311 are arranged in a plurality of rows (for example, arranged in two rows), and the plurality of rows are staggered in multiple rows.

Preferably, a ratio of a cross-sectional width of one through hole 311 in the same column in the width direction or the sum of cross-sectional widths of a plurality of through holes 311 in the same column in the width direction to the width of the conductive layer 310 is smaller than or equal to 1/2. In this embodiment of the present application, when there is only one through hole 311 in the same column, a ratio of the cross-sectional width of the through hole 311 in the width direction (i.e., the short axis c1 of the ellipse through hole 311) to the width c2 of the conductive layer 310 is smaller than or equal to 1/2; or when there are two through holes 311 in the same column, a ratio of the sum of the cross-sectional width of the two through holes 311 in the width direction (i.e., the sum of the cross-sectional width c5 and the cross-sectional width c6) to the width c2 of the conductive layer 310 is smaller than or equal to 1/2. Further, a ratio of the minimum spacing $c_3$ between two adjacent through holes 311 in the same row to the longest side or the longest side connecting line (i.e. the long axis $c_4$ of the ellipse through hole 311) is greater than or equal to 1/2 and smaller than or equal to 2. Thereby, the bending resistance of the power line 31 can be improved, and the power line 31 can be made to have better electrical conductivity.

Accordingly, the present embodiment also provides a manufacturing method of the flexible display device, which includes: forming a flexible substrate; determining resistance requirement of a power line; obtaining information about through holes and a width of a conductive layer according to the resistance requirement of the power line; and forming the power line on the flexible substrate according to the information about the through holes and the width of the conductive layer. Here, forming the power line on the flexible substrate may include: firstly forming the conductive layer with a specific width (i.e., obtaining the width of the conductive layer in accordance with the resistance requirement of the power line); and then punching the conductive layer (i.e., the conductive layer is punched in accordance with the information about the through holes, such as the shape, the size, the number of rows and the number of the through holes, which is obtained by the resistance requirement of the power line).

Fourth Embodiment

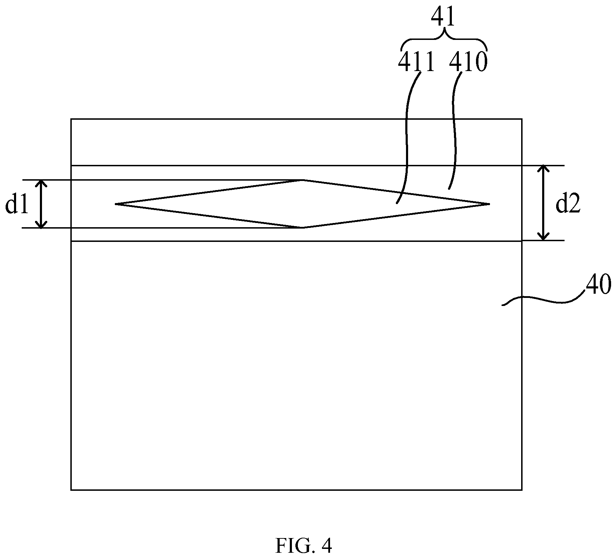

FIG. 4 is a structural schematic diagram of a flexible display device in accordance with a fourth embodiment of the disclosure. As shown in FIG. 4, the flexible display device includes a flexible substrate 40 and a power line 41 disposed thereon, the power line 41 includes a conductive layer 410 having a through hole 411 disposed therein. By using the through hole 411, the stress produced by bending the power line 41 may be dispersed, thereby preventing the power line from being cracked or broken in the process of bending or folding the flexible display device, and improving the quality and reliability of the power line during it is bent.

In this embodiment, the material of the conductive layer 410 may be a metal material such as aluminum or copper, and the conductive layer 410 may also be a composite metal layer composed of a plurality of metal materials, and further the conductive layer 410 may also be a conductive layer composed of transparent materials such as indium tin oxide. Other materials may be used for the conductive layer 410 as long as they are electrically conductive.

Preferably, a longest one of all sides of any through hole 411 or a longest one of all side connecting lines that connect two points of the sides of the through hole 411 is consistent with a bending direction of the power line 41. Continuing to refer to FIG. 4, in this embodiment of the present application, the shape of the through hole 411 is rhombus. Further, the long diagonal line of the rhombic through hole (i.e., the longest side connecting line) is consistent with the bending direction of the power line 41, that is, the long diagonal line of the rhombic through hole is consistent with the bending direction of the flexible display device. Thereby, the stress produced by bending the power line 41 may be better dispersed by the through holes 411.

Preferably, a row of through holes 411 is disposed on the conductive layer 410 every 200 μm-500 μm in the width direction, and one or more rows of through holes 411 are evenly arranged on the conductive layer 410, thereby, a certain number of through holes can be ensured, so that the stress generated by bending the power line 41 is better dispersed, and the quality and reliability of the conductive layer 410 can also be ensured. Here, the number of the through holes 411 is one, and the through hole 411 is arranged on the middle position of the conductive layer 410. Further, a ratio of a cross-sectional width of the through hole 411 in the same column in the width direction or the sum of cross-sectional widths of the plurality of through holes 411 in the same column in the width direction to the width of the conductive layer 410 is smaller than or equal to 1/2. In this embodiment of the present application, a ratio of the short diagonal line $d_1$ of the rhombic through hole 411 to the width $d_2$ of the conductive layer 410 is smaller than or equal to 1/2. Thereby, the bending resistance of the power line 41 can be improved, and the power line 41 can be made to have better electrical conductivity.

Accordingly, the present embodiment also provides a manufacturing method of the flexible display device, which includes: forming a flexible substrate; determining resistance requirement of a power line; obtaining information about a through hole and a width of a conductive layer according to the resistance requirement of the power line; and forming the power line on the flexible substrate according to the information about the through hole and the width of the conductive layer. Here, forming the power line on the flexible substrate may include: firstly forming the conductive layer with a specific width (i.e., obtaining the width of the conductive layer in accordance with the resistance requirement of the power line); and then punching the conductive layer (i.e., the conductive layer is punched in accordance with the information about the through hole, such as the shape, the size, the number of rows and the number of the through hole, which is obtained by the resistance requirement of the power line).

In the flexible display device provided by the embodiment of the disclosure, the through hole may also have other shapes, such as circular shape, square shape, and irregular shape and so on. Preferably, the shape of the through hole is regular, so that the information about the through hole such as the shape, the size, the number of rows and the number thereof, and so on may be obtained conveniently according to the resistance requirement of the power line, and the through hole may be manufactured conveniently in accordance with the information.

It can be understood that the through hole on the conductive layer of the flexible display device provided by the embodiments of the disclosure may also be a recessed region of other shapes (such as a blind hole or a region mixed with a through hole and a blind hole), and the specific shape of the recessed region is not limited in the embodiments of disclosure.

In an embodiment of the disclosure, the flexible display device utilizes a thin film transistor structure, the conductive layer is electrically connected with a source electrode, a drain electrode, a gate electrode, a cathode or an anode of the flexible display device; or the conductive layer forms the source electrode, the drain electrode, the gate electrode, the cathode or the anode of the flexible display device. It can be seen that, since the conductive layer provided by the embodiment of the disclosure is provided with a recessed region that is capable of dispersing bending stress, when the conductive layer forms different conductive portions of the flexible display device, the bending resistance of the different conductive portions is improved. However, in the disclosure, which specific portions of the flexible display device is formed by the conductive layer is not limited.

It can be understood that the recessed region(for example, a through hole or a blind hole) of the conductive layer of the flexible display device provided by any of the above embodiments of the disclosure may be filled with an organic material to facilitate buffering the bending stress of the flexible display device.

In an embodiment of the disclosure, the projection of the shape of the at least one recessed region on a plane parallel to or perpendicular to the flexible substrate comprises one or multiple combinations of following shapes: a rectangle shape, a triangle shape, a trapezoid shape, a rhombus shape, a circular shape, an ellipse shape, a sinusoidal shape, a twisted shape and a zigzag shape. In the embodiment of the disclosure, the recessed region has a plurality of different shapes, which can fully disperse the stress of the conductive layer, and further disperse the stress influence of the flexible display device provided by the embodiment of the disclosure.

Fifth Embodiment

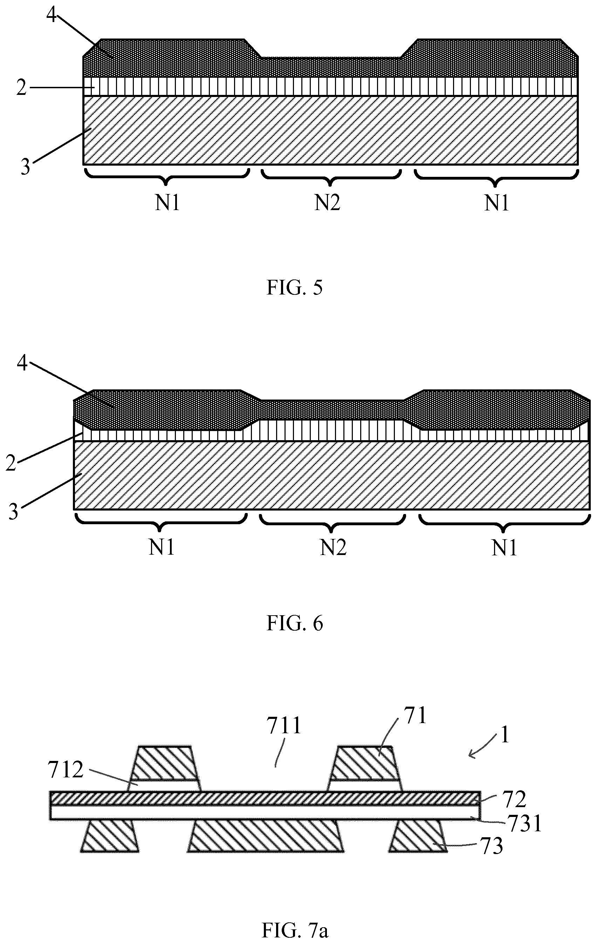

FIG. 5 is a structural schematic diagram of a flexible display device in accordance with a fifth embodiment of the disclosure. As shown in FIG. 5, the flexible display device provided by the fifth embodiment of the disclosure includes a conductive layer 4, an insulated layer 2 and a flexible substrate 3which are sequentially stacked in a top-down direction (from top to bottom as shown in FIG. 5). The conductive layer 4, the insulated layer 2 and the flexible substrate 3sequentially stacked in the top-down direction are divided into a bending zone N2 and a non-bending zone N1 along the extension direction. The thickness of the conductive layer 4 in the bending zone N2 is greater than that in the non-bending zone N1, that is, the lower edge of the conductive layer 4 in the bending zone N2 (the lower edge in the stacking direction as shown in FIG. 5) and the lower edge of the conductive layer 4 in the non-bending zone N1 (the lower edge in the stacking direction as shown in FIG. 5) are on the same horizontal line (i.e. collinear), and the upper edge of the conductive layer 4 in the bending zone N2 (the upper edge in the stacking direction as shown in FIG. 5) is lower than the upper edge of the conductive layer 4 in the non-bending zone N1 (the upper edge in the stacking direction as shown in FIG. 5) along the horizontal direction.

It can be noted that the extension direction mentioned in the embodiment of the disclosure refers to the horizontal direction, that is, the left-right direction as shown in FIG. 5, and a non-extension direction refers to the vertical direction, that is, the top-down direction as shown in FIG. 5.

It can be understood that the flexible display device provided by the embodiment of the disclosure may also exclude the insulated layer 2.

The theoretical basis of the embodiments of the disclosure is as follows.

The resistance of the conductive layer before improvement is:

$$R1 = \rho L / S1 \quad (1)$$

In formula (1), $S1=W*h1$, $W$ represents the width of the conductive layer, $L$ represents the length of the conductive layer, $h1$ represents the thickness of the conductive layer, $S1$ represents the cross-sectional area of the conductive layer, $\rho$ represents the density value of the conductive layer, $R1$ represents the resistance of the conductive layer.

The resistance of the conductive layer after improvement is:

$$R1' = \rho L / S' = \rho \left( \frac{L1}{S1} + \frac{L2}{S2} + \frac{L3}{S3} \right) = \rho \left( \frac{L1}{S1} + \frac{L-L1}{S2} \right) \quad (2)$$

In formula (2), the cross-sectional area $S1=W*h1$, $S2=W*(h1+h2)$, $S1=S3$, $S1<S2$, $L1$ represents the length of the conductive layer in the bending zone, $L2$ and $L3$ represent the length of the conductive layer 4 in the thickened non-bending zone, *L*1+*L*2+*L*3=*L, S*1 represents the cross-sectional area of the conductive layer corresponding to the bending zone, *S*2 and *S*3 represent the cross-sectional area of the conductive layer corresponding to the thickened non-bending zone.

The comparison of the resistance of the conductive layer before and after improvement is:

$$R1 - R1' = \frac{\rho L}{S1} - \rho\left(\frac{L1}{S1} + \frac{L-L1}{S2}\right) = \rho\left(\frac{L}{S1} - \frac{L1}{S1} - \frac{L-L1}{S2}\right) = \rho(L-L1)\left(\frac{1}{S1} - \frac{1}{S2}\right) (3)$$

In formula (3), *L-L*1>0, $\frac{1}{S1} - \frac{1}{S2} > 0$, therefore, *R*1>*R*1'.

In summary, it can be concluded through the above analysis that the resistance of the conductive layer can be effectively reduced after increasing the thickness of the conductive layer.

In the fifth embodiment of the disclosure, the flexible display device is divided into a bending zone and a non-bending zone in the extension direction, and the thickness of the conductive layer in the bending zone is greater than that in the non-bending zone, thereby achieving the purpose of reducing the resistance value of the conductive layer of the flexible display device without affecting the bending resistance of the bending zone of the flexible display device, and providing a necessary condition for applying the flexible display device to a large-screen foldable mobile terminal.

It can be understood that in the first embodiment of the disclosure, the upper edge of the conductive layer 4 in the bending zone N2 (the upper edge in the stacking direction as shown in FIG. 5) and the upper edge of the conductive layer 4 in the non-bending zone N1 (the upper edge in the stacking direction as shown in FIG. 5) are on the same horizontal line (i.e. collinear), and the lower edge of the conductive layer 4 in the bending zone N2 (the lower edge in the stacking direction as shown in FIG. 5) is higher than the lower edge of the conductive layer 4 in the non-bending zone N1 (the lower edge in the stacking direction as shown in FIG. 5) in the horizontal direction, thereby, achieving the purpose that the thickness of the conductive layer 4 in the bending zone N2 is greater than that in the non-bending zone N1. In this way, adaptability and expansibility of the flexible display device provided by the embodiment of the disclosure can be improved.

In addition, it can be noted that the specific setting range and setting locations of the bending zone N2 and the non-bending zone N1 can be set freely according to the actual situation, which is not limited herein.

Preferably, the conductive layer 4 in the embodiment of the disclosure is provided as a metal layer so that the conductive layer 4 can play a better role in conduction.

It can be understood that the conductive layer 4 may also be made with a material such as conductive plastic or conductive rubber and so on, which is not limited in the embodiment of the disclosure.

Sixth Embodiment

FIG. 6 is a structural schematic diagram of a flexible display device in accordance with a sixth embodiment of the disclosure. The sixth embodiment of the disclosure is extended on the basis of the fifth embodiment of the disclosure. The sixth embodiment of the disclosure is substantially the same as the fifth embodiment of the disclosure. The differences will be described detailed below, and the similarities will not be repeated. As shown in FIG. 6, the upper edge of the conductive layer 4 in the non-bending zone N1 of the flexible display device according to the sixth embodiment of the disclosure (the upper edge in the stacking direction as shown in FIG. 6) is higher than the upper edge of the conductive layer 4 in the bending zone N2 (the upper edge in the stacking direction as shown in FIG. 6) in the extension direction(i.e., the horizontal direction), and the lower edge of the conductive layer 4 in the non-bending zone N1 (the lower edge in the stacking direction as shown in FIG. 6) is lower than the lower edge of the conductive layer 4 in the bending zone N2 (the lower edge in the stacking direction as shown in FIG. 6) in the extension direction (i.e., the horizontal direction).

In the flexible display device of the sixth embodiment of the disclosure, the upper edge of the conductive layer 4 in the non-bending zone N1 is higher than that of the bending zone N2 in the extension direction (i.e., the horizontal direction), and the lower edge of the conductive layer 4 in the non-bending zone N1 is lower than that of the bending zone N2 in the extension direction (i.e., the horizontal direction). That is, the thickness of the conductive layer 4 in the non-bending zone N1 is respectively increased from both sides of the non-extension direction (i.e. the vertical direction), thereby realizing the purpose of reducing the resistance value of the conductive layer 4 of the flexible display device without affecting the bending resistance of the bending zone N2 of the flexible display device.

It can be understood that in the flexible display devices provided by the above embodiments of the disclosure, the upper edge and/or the lower edge of the conductive layer 4 in the non-bending zone N1 and the upper edge and/or the lower edge of the conductive layer 4 in the bending zone N2 that corresponding to the non-bending zone N1 are on the same horizontal line. However, the upper edge and/or the lower edge of the conductive layer 4 in the non-bending zone N1 and the upper edge and/or the lower edge of the conductive layer 4 in the bending zone N2corresponding to the non-bending zone N1 may be just collinear, and are not required to be on the same horizontal line.

Alternatively, the upper edge and/or the lower edge of the conductive layer 4 in the bending zone N2 (the upper edge and the lower edge in the stacking direction as shown in FIG. 6) are in the shape of zigzag or wavy and so on, to fully improve the extensibility and the adaptability of the flexible display device provided by the embodiment of the disclosure.

Seventh Embodiment and Eighth Embodiment

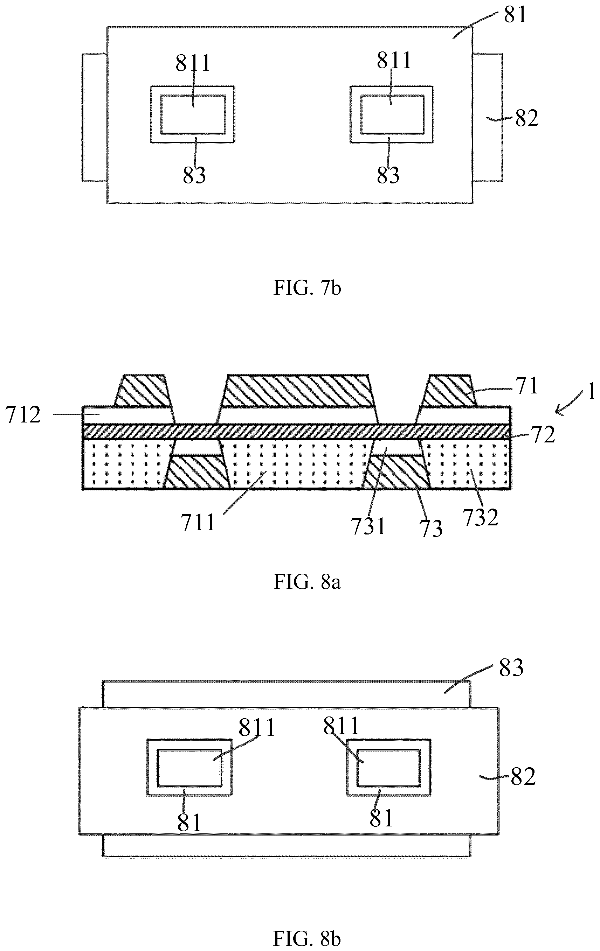

FIG. 7a is a structural schematic diagram of a thin film transistor structure of a flexible display device in accordance with a seventh embodiment of the disclosure. FIG. 7b is a projection schematic diagram of a gate electrode of the thin film transistor structure of the flexible display device in accordance with the seventh embodiment of the disclosure. As shown in FIG. 7a, a gate electrode 1 of the thin film transistor structure may include a top gate 71 disposed above a channel layer 72 of the thin film transistor structure and a bottom gate 73 disposed below the channel layer 72 of the thin film transistor structure. At least one through hole 711 is disposed on the top gate 71. Referring to FIG. 7b, a projection 811 of the through hole 711 of the top gate 71 on a plane 82parallel to the channel layer 72is covered by a projection 83 of the bottom gate 73 on the plane 82.

The gate electrode 1 is designed to include the bottom gate 73 and the top gate 71 disposed on both sides of the channel layer 72.The top gate 71 is provided with at least one through hole 711 which forms a complementary structure with the bottom gate 73. The through hole on the top gate 71 can disperse the stress concentration generated when the gate electrode 1 is bent or deformed, and enhance the bending resistance of the gate electrode 1, and may effectively prevent the bending or fracture failure of the thin film transistor structure. Meanwhile, since the top gate 71 and the bottom gate 73 form a complementary structure, although the top gate 71 has the at least one through hole 711 therein, the lower region of the channel layer corresponding to the at least one through hole 711 of the top gate 71 is covered by the bottom gate 73, a continuous conductive channel may still be constituted in the channel layer 72. Therefore, the gate electrode 1 provided with the complementary structure of the top gate 71 and the bottom gate 73 may not affect performance parameters of the thin film transistor structure (for example, aspect ratio of the thin film transistor structure).

FIG. 8a is a structural schematic diagram of a thin film transistor structure of a flexible display device in accordance with an eighth embodiment of the disclosure. FIG. 8b is a projection schematic diagram of the gate electrode of the thin film transistor structure of a flexible display device in accordance with the eighth embodiment of the disclosure. Referring to FIG. 8a and FIG. 8b, a gate electrode 1 of the thin film transistor structure may include a top gate 71 disposed above a channel layer 72 of the thin film transistor structure and a bottom gate 73 disposed below the channel layer 72of the thin film transistor structure. At least one through hole 711 is disposed on the bottom gate 73. Referring to FIG. 8b, a projection 811 of the through hole 711 of the bottom gate 73 on a plane 82 parallel to the channel layer 72is covered by a projection 81 of the top gate 71 on the plane 82.

However, it can be understood that the structure of the gate electrode 1 provided by the embodiment of the disclosure is not limited thereto, the structure of the gate electrode 1 may also be that each of the top gate 71 and the bottom gate 73 is provided with at least one through hole 711. As long as the projection 811 of the through hole 711 of the top gate 71 on the plane 82 parallel to the channel layer 72is covered by the projection 83 of the bottom gate 73 on the plane 82, and the projection 811 of the through hole 711 of the bottom gate 73 on the plane 82 parallel to the channel layer 72is covered by the projection 81 of the top gate 71 on the plane 82. In the following embodiments, the embodiment of the disclosure will be described only by taking an example that the through hole 711 is disposed on the top gate 71, however, whether the through hole 711 is disposed on the top gate 71 or the bottom gate 73 is not limited by the embodiments of the disclosure.

With continued reference to FIG. 7a and FIG. 7b, in an embodiment, the shape of the projection 811 of the through hole 711 of the top gate 71 on the plane 82 parallel to the channel layer 72 may be the same as that of the projection 83 of the bottom gate 73 on the plane 82. At this time, the overlapped area of the projection 811 of the top gate 71 on the plane 82 parallel to the channel layer 72 and the projection 83 of the bottom gate 73 on the plane 82 is the smallest. Therefore, the performance of the thin film transistor structure may be improved to some extent. However, it can be understood that, considering process variations and misplacement between layers, the overlapped area of the projection 811 of the top gate 71 on the plane 82 parallel to the channel layer 72 and the projection 83 of the bottom gate 73 on the plane 82 is allowable.

In a further embodiment, as shown in FIG. 8a, the bottom gate insulated layer 731 may further include a hollow region or at least one opening, and the hollow region or the at least one opening may be filled with organic material 732 so as to ensure the smoothness of the channel layer 72 above the bottom gate insulated layer 731;meanwhile, it is also more advantageous to buffer the bending stress by filling the at least one opening with the organic material 732 which is more resistant to bending. However, it can be understood that the top gate insulated layer 712 may also include a hollow region or at least one opening, and the hollow region or the at least one opening may also be filled with the organic material 732. Although in the embodiment shown in FIG. 8a, the shape of the hollow region of the bottom gate insulated layer 731 is exactly complementary to the bottom gate 73. However, it can be understood that in the embodiment of the disclosure, the shape of the hollow region of the top gate insulated layer 712 and/or the location of the opening and that of the bottom gate insulated layer 731 are not limited to those shown in FIG. 7a. The shape of the hollow region of the top gate insulated layer 712 or that of the bottom gate insulated layer 731 is not limited by the embodiment of the disclosure, and the location and the number of the opening of the top gate insulated layer 712 or the bottom gate insulated layer 731 is not limited by the embodiment of the disclosure.

Although FIG. 7b shows that the number of through holes 711 of the top gate 71 is one, but the number of through holes 711 of the top gate 71 provided by the embodiment of the disclosure may be two or more. When the top gate 71 is provided with a plurality of through holes 711, the plurality of through holes 711 may be arranged in one or more rows. The number of the through holes 711 and the specific arrangement manner of the through holes 711 are not limited by the embodiment of the disclosure.

In summary, the seventh and eighth embodiments of the disclosure solve the problem of display failure caused by stress concentration during bending deformation of the thin film transistor structure by disposing a recessed region on the gate electrode of the thin film transistor structure in the flexible display device.

Ninth Embodiment

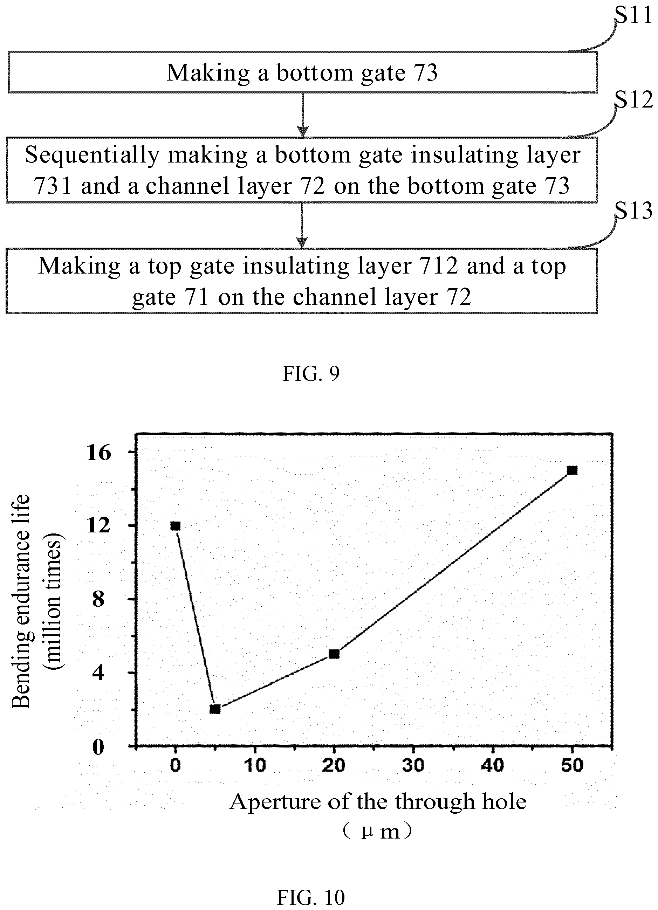

FIG. 9 is a flowchart showing the production process of a gate electrode of a thin film transistor structure of a flexible display device in accordance with a ninth embodiment of the disclosure. As shown in FIG. 9, the ninth embodiment of the disclosure provides a method of manufacturing a gate electrode of a thin film transistor structure which includes:

S11, making a bottom gate 73.At least one through hole 711 is required to be disposed on the bottom gate 73 when the bottom gate 73 is made, and the projection of the at least one through hole 711 on the plane 82 parallel to a channel layer 72 may be covered by the projection of a top gate 71 that is subsequently made on the plane 82. It may be understood that the bottom gate 73 may be prepared on a substrate. The material and internal structure of the substrate are not limited in the embodiment of the disclosure.

S12, sequentially making a bottom gate insulated layer 731 and a channel layer 72 on the bottom gate 73.The bottom gate insulated layer 731 is configured to form insulation between the bottom gate 73 and the channel layer 72.

S13, making a top gate insulated layer 712 and a top gate 71 on the channel layer 72.At least one through hole 711 may be prepared on the top gate 71 when the top gate 71 is made, and the projection of the at least one through hole 711 on the plane 82 parallel to the channel layer 72 may be covered by the projection of the bottom gate 73 on the plane 82.

By using the method of manufacturing the gate electrode 1 provided in this embodiment, the gate electrode 1 includes the bottom gate 73 and the top gate 71 prepared on both sides of the channel layer 72 respectively, at least one through hole 711 is provided on the top gate 71 and/or the bottom gate 73, the top gate 71 and the bottom gate 73 constitute a complementary structure. This can enhance the bending resistance of the gate electrode 1 while ensuring the electrical properties of the thin film transistor structure.

Tenth Embodiment

FIG. 10 is a schematic diagram of bending performance experimental data of a flexible display device in accordance with a tenth embodiment of the disclosure. In the tenth embodiment of the disclosure, the power line used in the bending performance experiment is a metal wire with a width of 500 $\mu$m, and the conductive layer of the power line is covered without the protective layer(i.e., the test part is a non-AA area of the power line, a non-display area). As shown in FIG. 10, the horizontal axis of the coordinate in FIG. 10 represents an aperture of the through hole of the power line, and the vertical axis of the coordinate represents the bending endurance life of the power line. In the bending performance experiment of the tenth embodiment of the disclosure, the schematic diagram of bending performance experiment is formed as shown in FIG. 10 by repeatedly testing the bending endurance life of the power line without the protective layer under different apertures of the through hole.

By analyzing FIG. 10, it can be seen that, when the aperture of the through hole of the power line is equal to40 $\mu$m, the bending endurance life of the power line is approximately equal to that of the power line in which the aperture of the through hole is equal to 0 $\mu$m; and when the aperture of the through hole of the power line is greater than 40 $\mu$m, the bending endurance life of the power line increases linearly; and when the aperture of the through hole of the power line is equal to 50 $\mu$m, the bending endurance life of the power line is obviously higher than that of the power line in which the aperture of the through hole is equal to 0 $\mu$m.

In addition, when the aperture of the through hole of the power line is smaller than 40 $\mu$m, since the aperture of the through hole is too small, the through hole itself may expand and break as a starting point of a crack, thereby reducing the stability of the flexible display device provided by the embodiment of the disclosure. As a result, when the aperture of the through hole of the power line is smaller than 40 $\mu$m, the bending resistance of the flexible display device is poor.

Since the width w of the power line is equal to 500 $\mu$m, it can be seen from FIG. 10 that, when $a$=40 $\mu$m, $a/_w$ =0.08; when $a$=50 $\mu$m, $a/_w$ =0.1.

In summary, when the value $a/_w$ of the power line area covered without the protective layer is greater than 0.08, the purpose of improving the bending endurance life of the power line without the protective layer may be achieved by means of disposing the through hole on the power line.

Preferably, the value $a/_w$ of the power line area covered without the protective layer is set to be greater than 0.1, so that the bending endurance life of the power line without the protective layer may be increased significantly.

For example, in an embodiment of the disclosure, the width w of the power line is equal to 10 $\mu$m, and the power line is covered without any other layer (such as an organic layer and so on), then the aperture of the through hole on the power line is greater than 0.8 $\mu$m, and preferably, the aperture of the through hole is greater than 1 $\mu$m.

It can be understood that the through holes formed on the power line may be replaced by blind holes in the flexible display device described in the tenth embodiment of the disclosure, so as to avoid the influence on performance of other structures of the flexible display device caused by preparation process of the through hole. That is to say, the flexible display device provided by the embodiment of the disclosure may include only through hole or blind holes, or the through holes and the blind holes may coexist.

It can be understood that in the tenth embodiment of the disclosure, the through hole or the blind hole may be a rectangular hole, a triangular hole, a trapezoidal hole, a rhombus hole, a circular hole, an elliptical hole or an irregular hole and so on. When the through hole or the blind hole is a square hole, the aperture a is equal to a side length of the square hole, and when the through hole or the blind hole is a circular hole, the aperture a is equal to the diameter of the circular hole; when the through hole or the blind hole is an irregular hole, the aperture a is equal to the length of the shortest side of the irregular hole, or equal to the length of the shortest side connecting line of the irregular hole. Here, a side connecting line means the line that connects two points of the sides of the irregular hole.

In the flexible display device provided by the tenth embodiment of the disclosure, the bending endurance life of the metal wire covered without the protective layer is improved by disposing the through hole and/or the blind hole on the region of the metal wire covered without the protective layer and limiting the ratio of the aperture of the through hole and/or the blind hole to the width of the metal wire.

Eleventh Embodiment

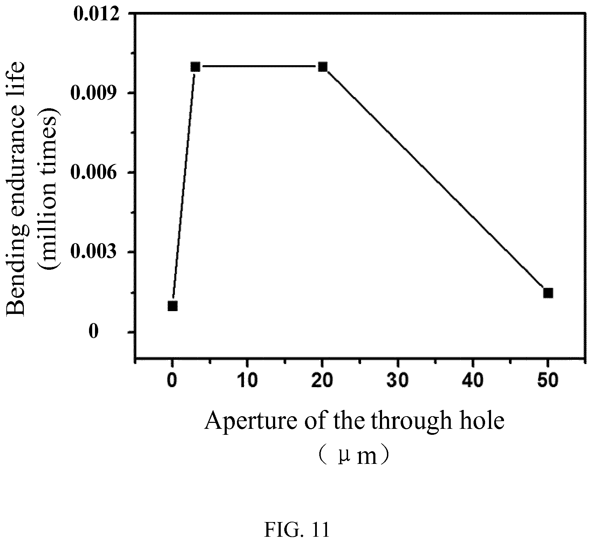

FIG. 11 is a schematic diagram of bending performance experimental data of a flexible display device in accordance with an eleventh embodiment of the disclosure. In the eleventh embodiment of the disclosure, the power line used in the bending performance experiment is a metal wire with a width of 500 $\mu$m, and the conductive layer of the power line is covered with the protective layer (i.e., the test part is an AA area of the power line, a display area). As shown in FIG. 11, the horizontal axis of the coordinate in FIG. 11 represents an aperture of the through hole of the power line, and the vertical axis of the coordinate represents the bending endurance life of the power line. In the bending performance experiment of the embodiment of the disclosure, the schematic diagram of bending performance experiment is formed as shown in FIG. 11 by repeatedly testing the bending endurance life of the power line with the protective layer under different apertures of the through hole.

By analyzing FIG. 11, it can be seen that, when the aperture of the through hole of the power line is equal to 50 $\mu$m, the bending endurance life of the power line is approximately equal to that of the power line in which the aperture of the through hole is equal to 0 $\mu$m; and when the aperture of the through hole of the power line is smaller than50 $\mu$m, the bending endurance life of the power line is all higher than that of the power line in which the aperture of the through hole is equal to 0 $\mu$m; and when the aperture range of the through hole of the power line is between 5 $\mu$m and 35 $\mu$m, the bending endurance life of the power line is obviously higher than that of the power line in which the aperture of the through hole is equal to 0 $\mu$m.

Since the width w of the power line is equal to 500 $\mu$m, it can be seen from FIG. 11 that, when $a$=50 $\mu$m, $a/_w$ =0.1; when $a$=5 $\mu$m, $a/_w$ = 0.01; when $a$=20 $\mu$m, $a/_w$ = 0.04; when $a$ =35 $\mu$m, $a/_w$ = 0.07.

In summary, when the value $a/_w$ of the power line area covered with the protective layer is smaller than 0.1, the purpose of improving the bending endurance life of the power line with the protective layer may be achieved by means of disposing the through hole on the power line.

Preferably, the value $a/_w$ of the power line area covered by the protective layer is set to be 0.01-0.07,so that the bending endurance life of the power line with the protective layer may be increased significantly.

Preferably, the value $^a/_w$ of the power line area covered by the protective layer is set to be 0.01-0.04,so that the bending endurance life of the power line with the protected layer is increased by 500%.

For example, in an embodiment of the disclosure, the width $w$ of the power line is equal to 400 $\mu$m, and the power line is coated with a pillar layer (i.e. the protective layer), and the aperture of the through hole on the power line is smaller than40 $\mu$m, so that the purpose of improving the bending endurance life of the power line with the protective layer can be achieved.

Preferably, in an embodiment of the disclosure, the width $w$ of the power line is equal to 400 $\mu$m, and the power line is coated with the pillar layer (i.e. the protective layer), and the aperture range of the through hole is set between 4 $\mu$m and 16 $\mu$m, so that the bending endurance life of the power line with the protective layer is increased by 500%.

It can be understood that the through holes formed on the power line may be replaced by blind holes in the flexible display device described in the eleventh embodiment of the disclosure, so as to avoid the influence on performance of other structures of the flexible display device caused by preparation process of the through hole. That is to say, the flexible display device in the embodiment of the disclosure may include only through holes or blind holes, or the through holes and the blind holes may coexist.

It can be understood that in the eleventh embodiment of the disclosure, the through hole or the blind hole may be a rectangular hole, a triangular hole, a trapezoidal hole, a rhombus hole, a circular hole, an elliptical hole or an irregular hole and so on. When the through hole or the blind hole is a square hole, the aperture a is equal to a side length of the square hole, and when the through hole or the blind hole is a circular hole, the aperture a is equal to the diameter of the circular hole; when the through hole or the blind hole is an irregular hole, the aperture a is equal to the length of the longest side of the irregular hole, or equal to the length of the longest side connecting line of the irregular hole, a side connecting line is the line that connects two points of sides of the irregular hole.

In the flexible display device provided by the eleventh embodiment of the disclosure, the bending endurance life of the metal wire covered with the protective layer is improved by disposing the through hole and/or the blind hole on the region of the metal wire covered with the protective layer and limiting the ratio of the aperture of the through hole and/or the blind hole to the width of the metal wire.

In an embodiment of the disclosure, a flexible wire (such as the power line) provided by the above embodiment of the disclosure is applied to the anode and cathode structure, to improve the bending endurance life of the anode and cathode structure.

The above embodiments are only the preferred embodiments of the disclosure and are not intended to limit the protection scope of the disclosure. Any modifications, equivalent substitutions, improvements, etc. that are made within the spirit and principles of the disclosure are intended to be embraced within the protection scope of the disclosure.

**Claims**

1.  A flexible display device, comprising:

    a flexible substrate; and
    a conductive layer disposed on the flexible substrate, and having at least a recessed region disposed thereon.

2.  The flexible display device in accordance with claim 1, wherein the conductive layer forms a power line on the flexible substrate.

3.  The flexible display device in accordance with claim 1, wherein a longest one of all sides of the recessed region or a longest one of all side connecting lines that connect two points of the sides of the recessed region is consistent with a bending direction of the flexible display device.

4.  The flexible display device in accordance with any one of claims 1 to 3, wherein the recessed region comprises a through hole and/or a blind hole.

5.  The flexible display device in accordance with claim 1, wherein the conductive layer and the flexible substrate are divided into a bending zone and a non-bending zone along an extension direction, and the recessed region is disposed on the bending zone of the conductive layer; a thickness of the conductive layer in the bending zone is greater than a thickness of the conductive layer in the non-bending zone.

6.  The flexible display device in accordance with claim 1, wherein the flexible display device utilizes a thin film transistor structure, the conductive layer is electrically connected with a source electrode, a drain electrode, a gate electrode, a cathode or an anode of the flexible display device; or the source electrode, the drain electrode, the gate electrode, the cathode or the anode of the flexible display device is constituted by the conductive layer.

7. The flexible display device in accordance with claim 1, wherein the at least a recessed region of the conductive layer is filled with an organic material.

8. The flexible display device in accordance with claim 1, wherein the at least a recessed region is arranged in one or more rows along a bending direction of the flexible display device.

9. The flexible display device in accordance with claim 8, wherein the recessed regions arranged in a plurality of rows are aligned or staggered.

10. The flexible display device in accordance with claim 9, wherein a ratio of a cross-sectional width of one recessed region in a width direction of a power line or the sum of cross-sectional widths of a plurality of recessed regions in a same column in the width direction of the power line to a width of the conductive layer is smaller than or equal to 1/2.

11. The flexible display device in accordance with claim 9, wherein a ratio of a minimum spacing between two adjacent recessed regions in a same row to a length of a side or a side connecting line consistent with a bending direction of the flexible display device is greater than or equal to 1/2 and smaller than or equal to 2.

12. The flexible display device in accordance with claim 1, wherein a projection of the at least a recessed region on a plane parallel to or vertical to the flexible substrate comprises one or multiple combinations of following shapes: a rectangle shape, a triangle shape, a trapezoidal shape, a rhombus shape, a circular shape, an ellipse shape, a sinusoidal shape, a twisted shape and a zigzag shape.

13. The flexible display device in accordance with claim 1, further comprising a protective layer disposed on the conductive layer, and a ratio of an aperture of the recessed region of the conductive layer covered by the protective layer to a width of the conductive layer is smaller than 0.1.

14. The flexible display device in accordance with claim 1, further comprising a protective layer disposed on the conductive layer, and a ratio of an aperture of the recessed region of the conductive layer covered without the protective layer to a width of the conductive layer is greater than 0.08.

15. A method of manufacturing a flexible display device in accordance with claim 2, comprising:

    forming a flexible substrate;
    determining resistance requirement of a power line;
    obtaining information about a width of a conductive layer and a recessed region according to the resistance requirement of the power line; and
    forming the power line on the flexible substrate according to the information about the width of the conductive layer and the recessed region.

FIG. 1

FIG. 2

FIG. 3

FIG. 4

FIG. 5

FIG. 6

FIG. 7a

FIG. 7b

FIG. 8a

FIG. 8b

S11

| Making a bottom gate 73 |

S12

| Sequentially making a bottom gate insulating layer 731 and a channel layer 72 on the bottom gate 73 |

S13

| Making a top gate insulating layer 712 and a top gate 71 on the channel layer 72 |

FIG. 9

FIG. 10

FIG. 11

# INTERNATIONAL SEARCH REPORT

International application No.

PCT/CN2017/116916

### A. CLASSIFICATION OF SUBJECT MATTER

H01L 27/12 (2006.01) i; H01L 21/77 (2017.01) i; H01L 51/52 (2006.01)n; G02F 1/13 (2006.01)n

According to International Patent Classification (IPC) or to both national classification and IPC

### B. FIELDS SEARCHED

Minimum documentation searched (classification system followed by classification symbols)

H01L, G02F

Documentation searched other than minimum documentation to the extent that such documents are included in the fields searched

Electronic data base consulted during the international search (name of data base and, where practicable, search terms used)

CNABS, CTXT, DWPI, CNKI: 柔性, 基板, 基底, 导电层, 洞, 应力, flexibility, base, substrate, conducting layer, hole, via, stress, press

### C. DOCUMENTS CONSIDERED TO BE RELEVANT

| Category* | Citation of document, with indication, where appropriate, of the relevant passages | Relevant to claim No. |
|---|---|---|
| X | CN 1828871 A (QUANTA DISPLAY INC.), 06 September 2006 (06.09.2006), description, page 1, the last paragraph to page 2, paragraph 4, and figures 1A-1D | 1, 2, 6, 7, 13-15 |
| Y | CN 1828871 A (QUANTA DISPLAY INC.), 06 September 2006 (06.09.2006), description, page 1, the last paragraph to page 2, paragraph 4, and figures 1A-1D | 3-5, 8-12 |
| Y | CN 103559944 A (NANCHANG O-FILM TECHNOLOGY CO., LTD. et al.), 05 February 2014 (05.02.2014), description, paragraphs 38-40, and figures 1-3 | 3-5, 8-12 |
| A | CN 1679189 A (STICHTING ENERGIEONDERZOEK CENTRUM NEDERLAND), 05 October 2005 (05.10.2005), entire document | 1-15 |

☐ Further documents are listed in the continuation of Box C.  ☒ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 15 March 2018 | 26 March 2018 |

| Name and mailing address of the ISA<br>State Intellectual Property Office of the P. R. China<br>No. 6, Xitucheng Road, Jimenqiao<br>Haidian District, Beijing 100088, China<br>Facsimile No. (86-10) 62019451 | Authorized officer<br><br>WU, Haitao<br><br>Telephone No. (86-10) 62089265 |

Form PCT/ISA/210 (second sheet) (July 2009)

## INTERNATIONAL SEARCH REPORT
Information on patent family members

International application No.

PCT/CN2017/116916

| Patent Documents referred in the Report | Publication Date | Patent Family | Publication Date |
|---|---|---|---|
| CN 1828871 A | 06 September 2006 | None | |
| CN 103559944 A | 05 February 2014 | CN 103559944 B | 17 August 2016 |
| CN 1679189 A | 05 October 2005 | CA 2491469 C | 03 November 2009 |
| | | DE 60307277 D1 | 14 September 2006 |
| | | JP 4585850 B2 | 24 November 2010 |
| | | NO 20050172 A | 01 March 2005 |
| | | KR 100733083 B1 | 29 June 2007 |
| | | AU 2003254966 A1 | 23 January 2004 |
| | | EP 1518285 B1 | 02 August 2006 |
| | | DK 1518285 T3 | 04 December 2006 |
| | | DE 60307277 T2 | 11 January 2007 |
| | | WO 2004006365 A1 | 15 January 2004 |
| | | IL 166091 D0 | 15 January 2006 |
| | | IS 7631 A | 05 January 2005 |
| | | AU 2003254966 B2 | 20 December 2007 |
| | | JP 2006500735 A | 05 January 2006 |
| | | CN 100365854 C | 30 January 2008 |
| | | NO 20050172 D0 | 12 January 2005 |
| | | US 7851104 B2 | 14 December 2010 |
| | | NL 1020985 C2 | 06 January 2004 |
| | | KR 20050045984 A | 17 May 2005 |
| | | CA 2491469 A1 | 15 January 2004 |
| | | EP 1518285 A1 | 30 March 2005 |
| | | US 2006093887 A1 | 04 May 2006 |
| | | AT 335290 T | 15 August 2006 |

Form PCT/ISA/210 (patent family annex) (July 2009)